# EUROPEAN PATENT APPLICATION

(11) **EP 4 683 437 A1**
(43) Date of publication of application: **21.01.2026**
(21) Application number: 23927838.5
(22) Date of filing: 10.10.2023
(51) Int. Cl.: H05K 3/34, B23K 1/08

(54) **PREHEATING MECHANISM OF JET SOLDERING APPARATUS, AND JET SOLDERING APPARATUS**

(30) Priority: 17.03.2023 JP 2023043624
(71) Applicant: Koki Tec Corp., Kawagoe City, Saitama 350-0833 (JP)
(72) Inventor: SAKATA, Koji, Kawagoe City, Saitama 3500833 (JP)
(74) Representative: SSM Sandmair
(86) International application number: PCT/JP2023/036669
(87) International publication number: WO 2024/195162

(57) **Abstract**

The purpose of the present invention is to provide a preheating mechanism of a jet soldering apparatus capable of heating efficiently until an upper portion of a through hole of a substrate, and in which a solder reaches an upper portion of the hole without stopping a wetting by a solidification of a solder, and the jet soldering apparatus. A preheating mechanism 50 for a jet soldering apparatus for preheating a soldering position 30 of a printed circuit board 10 and its periphery, associated with a soldering apparatus for partially soldering the soldering position 30 of the printed circuit board 10 by drawing up a molten solder from a jet nozzle 40, at least comprising: one or more electromagnetic coils 51; a mounting unit 52 for mounting the one or more electromagnetic coils 51 at a periphery of the jet nozzle 40; and an alternating current power source and a controller 53 for flowing an alternating current to the one or more electromagnetic coils 51 and for controlling on/off of the alternating current, wherein the mounting unit 52 is arranged at a position that the soldering position 30 of the printed circuit board 10 and its periphery can be preheated by an electromagnetic induction heating using the one or more electromagnetic coils 51, and a timing of heating, a heating time, and a power applied to the one or more electromagnetic coils 51 are controlled by the alternating current power source and the controller 53.

## Description

### BACKGROUND OF THE INVENTION

### Field of the Invention

The present invention relates to a preheating mechanism of a jet soldering apparatus for preheating a soldering position of a printed circuit board and its periphery, associated with a soldering apparatus for partially soldering the soldering position of the printed circuit board by drawing up a molten solder from a jet nozzle, and to the jet soldering apparatus. The present application claims priority based on Japanese Patent Application No. 2023-43624 filed in Japan on March 17, 2023, which is incorporated by reference herein.

### Description of Related Art

When soldering by inserting a lead component into a through hole (plain hole) of a printed circuit board, there is a local soldering apparatus for soldering by ejecting a molten solder from a cylindrical jet nozzle from a soldering surface (mainly lower surface).

In a local soldering apparatus, only a part of a printed circuit board is heated for a local soldering, so a temperature rise of a periphery and a component surface (upper surface of substrate) is little. This is an advantage as a heat stress to a peripheral component is low, on the other hand, this is also a disadvantage as a wetting up to an upper portion in a through hole and a wet spreading of a solder is deteriorated by a solidification of a solder.

As a countermeasure, it may be heated by a hot air (heated air, heated nitrogen gas, or the like) or a radiation heating (infrared heater or the like) from a soldering surface (mainly lower surface), but a temperature rise of a peripheral substrate resin (base material) will be faster than a component electrode or a pattern to be soldered.

Due to a local heating, a component electrode or a pattern to be soldered is having a high heat conductivity and tends to release heat to a periphery, and also, an electrode or a pattern having a large heat capacity such as a large component requires time for heating.

For example, in Patent Literatures 1 to 3, it is described to perform soldering by arranging a high frequency induction heating head at a soldering position, and in Patent Literature 4, it is described to solder bonding by induction heating a portion to be soldered by an electromagnetic induction heating.

The inventions relating to Patent Literatures 1 to 4 are not the inventions to supply a molten solder by a jet nozzle, and their purpose are to perform a soldering by melting a solder by an electromagnetic induction heating. Also, in the inventions relating to Patent Literatures 1 to 3, a solder is melted by interposing an electrode with high frequency induction heating heads or by bringing high frequency induction heating heads closer to an electrode, so when connector terminals are aligned in multiple rows, it may not be interposed, and a solder may not be melted.

Also, in Patent Literature 5, a device for removing an electronic member by an electromagnetic induction heating is described, and in Patent Literatures 6 to 8, it is described to melt a solder disposed between two bonding members by an electromagnetic induction heating.

However, the inventions relating to Patent Literatures 5 to 8 are limited to small components or a local reflow.

Patent Literature 1: JP 2022-059164 A
Patent Literature 2: JP 2021-190295 A
Patent Literature 3: JP 2022-122539 A
Patent Literature 4: JP 2017-163015 A
Patent Literature 5: JP 7128994 B
Patent Literature 6: WO2019/073581
Patent Literature 7: JP 6915843 B
Patent Literature 8: WO2018/051475

### SUMMARY OF THE INVENTION

Here, considering the circumstances of the prior arts, the purpose of the present invention is to provide a preheating mechanism of a jet soldering apparatus capable of heating efficiently until an upper portion of a through hole of a substrate, and in which a solder reaches an upper portion of the hole without stopping a wetting by a solidification of a solder, and to the jet soldering apparatus.

One embodiment of the present invention for solving the above problem is a preheating mechanism of a jet soldering apparatus for preheating a soldering position of a printed circuit board and its periphery, associated with a soldering apparatus for partially soldering the soldering position of the printed circuit board by drawing up a molten solder from a jet nozzle, at least comprising: one or more electromagnetic coils; a mounting unit for mounting the one or more electromagnetic coils at a periphery of the jet nozzle; and an alternating current power source and a controller for flowing an alternating current to the one or more electromagnetic coils and for controlling on/off of the alternating current, wherein the mounting unit is arranged at a position that the soldering position of the printed circuit board and its periphery can be preheated by an electromagnetic induction heating using the one or more electromagnetic coils, and a timing of heating, a heating time, and a power applied to the one or more electromagnetic coils are controlled by the alternating current power source and the controller.

At this time, in one embodiment of the present invention, a soft ferrite core may be applied to the one or more electromagnetic coils.

Also, in one embodiment of the present invention, the preheating mechanism may further comprise a heated gas supply mechanism for supplying a heated gas to the printed circuit board.

Also, in one embodiment of the present invention, a Curie temperature of the soft ferrite core may be 200 degrees Celsius or more.

Also, in one embodiment of the present invention, the soft ferrite core may be formed in a cylindrical shape surrounding the jet nozzle, and an electromagnetic coil of the one or more electromagnetic coils may be wound along a height direction of the core in a cylindrical shape.

Also, in one embodiment of the present invention, the soft ferrite core is formed in a U shape, and the core in U shape may be arranged at one or more positions around the jet nozzle.

Also, in one embodiment of the present invention, a groove may be formed in the soft ferrite core, and the electromagnetic coil may be embedded and wound in the groove.

Other embodiment of the present invention is a jet soldering apparatus comprising the preheating mechanism, the jet soldering apparatus comprising: a work supporting means for supporting a work in which a plurality of soldering positions are dispersed; a jet nozzle for ejecting a molten solder to a soldering position of the plurality of soldering positions; a preheating mechanism arranged at a periphery of the jet nozzle; and an access means in which respective distances from the jet nozzle to the plurality of soldering positions are moved closer when automatic soldering is performed and the respective distances are moved away while waiting.

According to the present invention, a metal part (pattern or electrode), which is difficult to be heated or takes time to be heated by a hot air or a radiation heating, will be self-heated by an electromagnetic induction heating (IH), so a target position can be heated effectively. Also, a temperature of an upper portion of a through hole can be increased, so a molten solder reaches an upper portion of the hole easily without stopping a wetting by a solidification of a solder.

### BRIEF DESCRIPTION OF THE DRAWINGS

FIG. 1 is a perspective view illustrating one embodiment of a jet soldering apparatus relating to the present invention.
FIG. 2 is a perspective view illustrating other embodiment of a jet soldering apparatus relating to the present invention.
FIG. 3(A) is a sectional view illustrating a preheating mechanism relating to one embodiment of the present invention arranged around a jet nozzle, and a state that an electronic component implemented on a printed circuit board is soldered by the jet nozzle, and FIG. 3(B) is a sectional view illustrating a preheating mechanism relating to other embodiment of the present invention.
FIG. 4(A) is a view illustrating an embodiment of an installation of an electromagnetic coil including a soft ferrite core relating to the preheating mechanism relating to one embodiment of the present invention, and FIG. 4(B) is a view illustrating a state that the electromagnetic coil is removed from FIG. 4(A).
FIG. 5 is a view illustrating an embodiment of an installation of an electromagnetic coil including a soft ferrite core relating to a preheating mechanism relating to other embodiment of the present invention.
FIG. 6(A) is a view illustrating a state seen from a component surface side when a component lead is soldered to a through hole by a conventional jet soldering, and FIG. 6(B) is a view illustrating a state seen from a component surface side when a component lead is soldered to a through hole by a jet soldering applying the preheating mechanism relating to the present invention.

### DETAILED DESCRIPTION OF THE INVENTION

Hereinafter, explaining in detail about a preheating mechanism of a jet soldering apparatus and the jet soldering apparatus relating to the present invention, with reference to the drawings. In addition, the present invention should not be limited by examples below, and it can be changed optionally within a scope not deviating from a gist of the present invention.

One embodiment of the present invention pertains to a soldering apparatus for partially soldering a soldering position of a printed circuit board by drawing up a molten solder from a jet nozzle. At first, explaining about a jet nozzle soldering apparatus applying the present invention, and then, explaining about a structure of a preheating mechanism relating to the present invention.

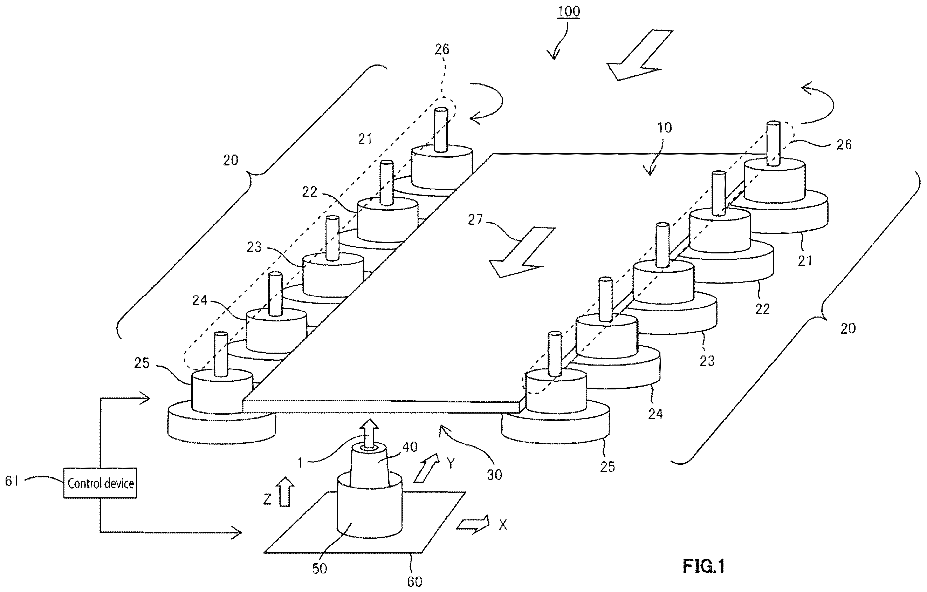

FIG. 1 is a perspective view illustrating one embodiment of a jet soldering apparatus relating to the present invention, and it is illustrating a state that a printed circuit board implementing an electronic component is conveyed to a predetermined position by a roller conveyer and soldered by a jet nozzle. As illustrated in FIG. 1, one embodiment of the present invention is a jet soldering apparatus 100 comprising a preheating mechanism 50 described later, and the jet soldering apparatus 100 comprises: a work supporting means 20 for supporting a work (printed circuit board 10) in which a plurality of soldering positions are dispersed; a jet nozzle 40 for ejecting a molten solder 1 to the soldering position 30; a preheating mechanism 50 arranged at a periphery of the jet nozzle 40; and an access means 60 in which respective distances from the jet nozzle 40 to the plurality of soldering positions 30 are moved closer when automatic soldering is performed and the respective distances are moved away while waiting.

In the jet soldering apparatus 100 in FIG. 1, the work supporting means 20 also functions as a work conveying means, for example a roller conveyer, and as illustrated in FIG. 1, longitudinal five axes rollers 21 to 25 are arranged sequentially at both sides of the work (printed circuit board 10) to interpose the work between the rollers, and the rollers function to convey the work in a conveying direction (arrow) 27 by integrally rotating in the conveying direction 27 by using a chain 26.

The work supporting means (work conveying means) 20 conveys the printed circuit board 10 according to a progress of a soldering process. The printed circuit board 10 charged into the jet soldering apparatus 100 reaches a position for performing a soldering process by the work supporting means 20. The jet nozzle 40 is always ejecting the molten solder 1 when the jet soldering apparatus 100 is operating, and ejects the molten solder 1 such that the molten solder 1 reaches the soldering position 30 of the printed circuit board 10 moved closer. The access means (nozzle drive unit) 60 is a drive mechanism capable of moving in XYZ directions for moving the jet nozzle 40 closer to the soldering position 30. A drive control of the work supporting means (work conveying means) 20 and the access means (nozzle drive unit) 60 is integrally controlled for example by a control device 61.

In addition, in the present invention, the work is mainly the printed circuit board 10, but it may be a work other than the printed circuit board 10, and the preheating mechanism relating to the present invention can be applied as long as it is a work in which a soldering position should be preheated.

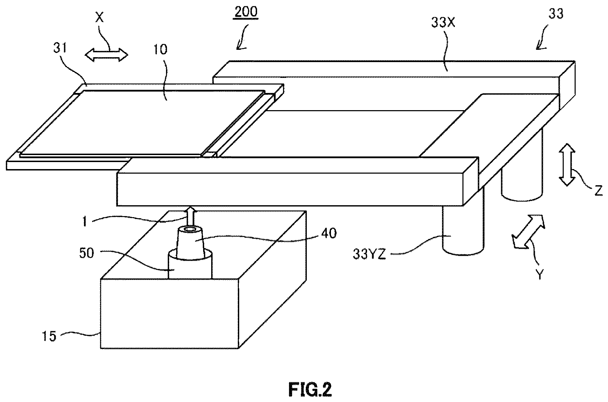

FIG. 2 is a perspective view illustrating other embodiment of a jet soldering apparatus relating to the present invention. As illustrated in FIG. 2, a jet soldering apparatus 200 comprises: a fixed-type solder bath 15; a table X axis driving unit (also referred to as "X axis driving rail") 33X located above the solder bath 15; table struts 33YZ; and a work fixing table (hereinafter, abbreviated as "table") 31 movable in a X direction above the table struts 33YZ. Also, a work (printed circuit board 10) is removably fixed to the table 31. In addition, in the jet soldering apparatus 200 in Fig. 2, the work fixing table 31 corresponds to the work supporting means, and the table X axis driving unit 33X (X axis driving rail) and the table struts 33YZ corresponds to the access means.

The jet nozzle 40 ejects a molten solder 1 to a soldering position. The access means 33 moves respective distances from the jet nozzle 40 to a plurality of soldering positions closer when performing an automatic soldering, on the other hand, moves the respective distances away while waiting. The access means 33 can move the work (printed circuit board 10) supported by the work supporting means (work fixing table 31) in XYZ directions with respect to the jet nozzle 40.

A main difference between the jet soldering apparatus 100 illustrated in FIG. 1 and the jet soldering apparatus 200 illustrated in FIG. 2 is that a nozzle side is moved in the jet soldering apparatus 100 (FIG. 1) and that a work side is moved in the jet soldering apparatus 200 (FIG. 2) in an access operation of the jet nozzle and the soldering position. The preheating mechanism 50 of the jet soldering apparatus relating to the present invention can be applied to both of the jet soldering apparatuses 100 and 200.

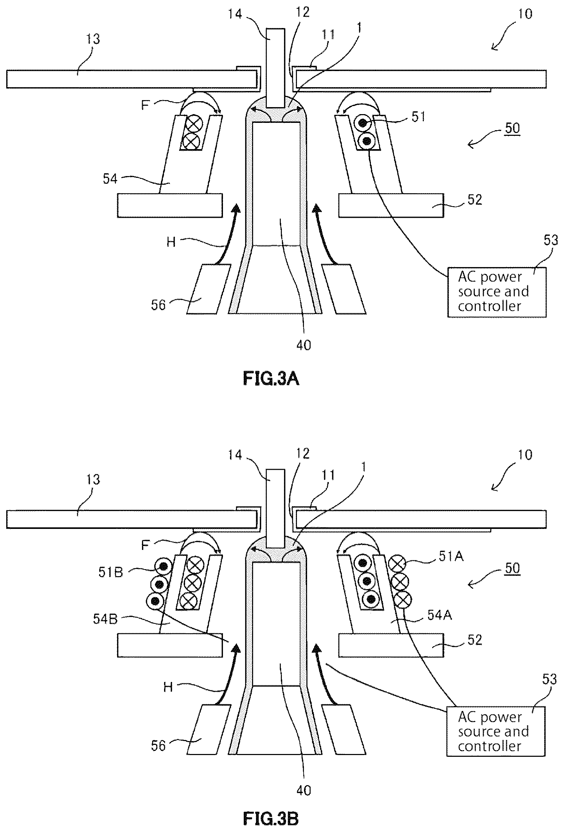

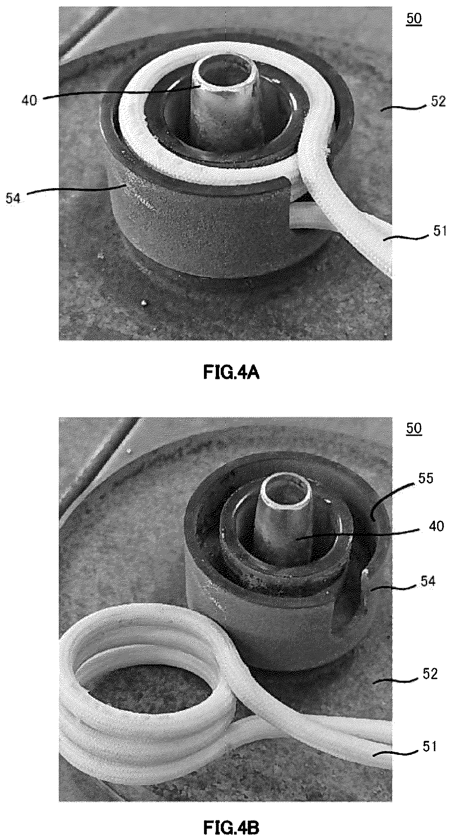

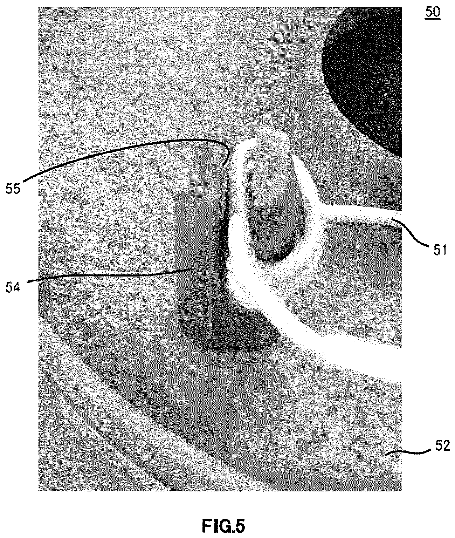

Next, explaining about a preheating mechanism of a jet soldering apparatus relating to the present invention. FIG. 3(A) and FIG. 3(B) are sectional views illustrating a preheating mechanism relating to one embodiment of the present invention arranged around a jet nozzle, and a state that an electronic component implemented on a printed circuit board is soldered by the jet nozzle. In addition, FIG. 3(A) is a view illustrating an embodiment of the following FIG. 4(A) and FIG. 4(B), and FIG. 3(B) is a view illustrating an embodiment of the following FIG. 5. One embodiment of the present invention is a preheating mechanism 50 of a jet soldering apparatus for preheating a soldering position 30 of a printed circuit board 10 and its periphery, associated with a soldering apparatus for partially soldering the soldering position 30 of the printed circuit board 10 by drawing up a molten solder 1 from a jet nozzle 40, at least comprising: one or more electromagnetic coils 51; a mounting unit 52 for mounting the one or more electromagnetic coils 51 at a periphery of the jet nozzle 40; and an alternating current power source and a controller 53 for flowing an alternating current to the one or more electromagnetic coils 51 and for controlling on/off of the alternating current, wherein the mounting unit 52 is arranged at a position that the soldering position 30 of the printed circuit board 10 and its periphery can be preheated by an electromagnetic induction heating using the one or more electromagnetic coils 51, and a timing of heating, a heating time, and a power applied to the one or more electromagnetic coils 51 are controlled by the alternating current power source and the controller 53.

The printed circuit board 10 to which a soldering is performed by the jet soldering apparatus 100 relating to the present invention is composed by assembling electronic components by penetrating a lead terminal 14 through a through hole 12 on a main surface of a substrate 13 forming many through holes 12 while print forming a conductor unit such as a predetermined circuit pattern and a land 11 on the main surface, as an example. The printed circuit board 10 is implemented by electrically and mechanically bonding the electronic components to the substrate 13 by performing a soldering to the land 11 and the lead terminal 14 penetrating the through hole 12.

For example, as illustrated in FIG. 3(A) and FIG. 3(B), the lead terminal 14 of electronic components penetrates from a component surface (upper surface) of the printed circuit board 10 to a soldering surface (lower surface), and penetrates from the through hole 12, in which a copper foil is exposed at the soldering surface, in a state that the lead terminal 14 is cut short. On the other hand, in the jet soldering apparatus 100, a control device 61 controls a nozzle drive unit 60 to move the jet nozzle 40 closer to the soldering position 30. In this way, when the jet nozzle 40 moves closer to the soldering position 30 while ejecting a solder 1, the lead terminal 14 is soldered to the land 11.

In the present invention, the one or more electromagnetic coils 51 are arranged at a periphery of the jet nozzle 40. By flowing an alternating current to the electromagnetic coils 51, a magnetic force line F (alternating magnetic field) is generated, and an overcurrent occurs at the lead terminal 14 and the land 11 at the through hole 12 of the printed circuit board 10 by this magnetic force line F, and an electromagnetic induction heating (IH) for heating by an electric resistance occurs. In this way, the through hole 12 of the printed circuit board 10 can be preheated, so when soldering by the jet nozzle 40 of the jet soldering apparatus 100, a solder can spread all over from a lower portion to an upper portion in the through hole 12 without solidifying in the through hole 12 on the way.

The mounting unit 52 is arranged for locating the one or more electromagnetic coils 51 at a periphery of the jet nozzle 40. In the jet soldering apparatus 100, when soldering, a solder is supplied from the jet nozzle 40 and an excess solder will be flown back through an outer wall of the jet nozzle 40, so the mounting unit 52 is arranged at a circumference of the jet nozzle 40 not to prevent these flows of a jet solder. Also, it is desirable to adjust an electromagnetic induction heating (IH) by the one or more electromagnetic coils 51 to a position that the heating will be generated at the soldering position 30 of the printed circuit board 10 efficiently. As an example, the one or more electromagnetic coils 51 are arranged at a position 10 to 40 mm in a horizontal direction from a center of the nozzle according to a diameter 2 to 20 mm of the jet nozzle 40. The one or more electromagnetic coils 51 are desired to be near the jet nozzle in a range not interrupting a path of a heating gas and a back flow of excess jet solder. The mounting unit 52 may be arranged at a position fixed with respect to the jet nozzle 40, or may be arranged such that a position and an angle of the one or more electromagnetic coils 51 will be movable.

The alternating current power source and the controller 53 controls on/off of an alternating current while flowing the alternating current to the one or more electromagnetic coils 51. In this way, a heating quantity and a timing of an electromagnetic induction heating of the soldering position 30 can be controlled by a time and an applied power to the electromagnetic coils 51. A control of an applied power can be performed, for example by a power adjustment by switching an applied voltage. When there are plural electromagnetic coils 51, an on/off control may be performed to each electromagnetic coil. Also, the present invention is used as the preheating mechanism 50 of the jet soldering apparatus 100 using a molten solder 1, so it is not always necessary to heat the soldering position 30 to or above a melting point of a solder, as the prior arts (Patent Literatures 1 to 4). Therefore, in the present invention, a preheating temperature by the preheating mechanism 50 may be set to be a melting point of a solder or less.

In one embodiment of the present invention, it is preferable that a soft ferrite core 54 is applied to the one or more electromagnetic coils 51. A soft ferrite is a ferrite functioning as a magnet when a magnetic field is generated by flowing a current to an electromagnetic coil, and it will not be magnetic by reverting to an original state when a magnetic field is dissipated as a current stopped flowing to the electromagnetic coil, and it is a type of ceramics in which a main ingredient is iron oxide. By using a soft ferrite core, a magnetic flux generated from the electromagnetic coil is irradiated to the soldering position 30 of the printed circuit board 10 efficiently to cause an electromagnetic induction heating (IH), and also, a heating quantity and a timing of an electromagnetic induction heating can be controlled in coordination with an on/off control of the alternating current power supply and the controller 53.

In one embodiment of the present invention, the preheating mechanism 50 may further comprises a heating gas supply mechanism 56 for supplying a heating gas H to the printed circuit board 10. As an example, it may comprise a mechanism for supplying a heated nitrogen gas from below to a periphery of a nozzle port of the jet nozzle 40. In this way, the soldering position 30 of the printed circuit board 10 can be heated, and also, a circumference of the nozzle port of the jet nozzle 40 will be a nitrogen gas atmosphere, and an oxidization of a molten solder 1 can be inhibited.

In one embodiment of the present invention, it is preferable that a Curie temperature of the soft ferrite core 54 is 200 degrees Celsius or more. The soft ferrite core 54 is also heated by the heating gas H supplied from the heating gas supply mechanism 56, so it is preferable to use a material with a Curie temperature of 200 degrees Celsius or more, in order to prevent stopping of an electromagnetic induction heating by losing a magnetic force.

FIG. 4(A) is a view illustrating an embodiment of an installation of an electromagnetic coil including a soft ferrite core relating to the preheating mechanism relating to one embodiment of the present invention, and FIG. 4(B) is a view illustrating a state that the electromagnetic coil is removed from FIG. 4(A). In one embodiment of the present invention, as illustrated in FIG. 4(A), a soft ferrite core 54 is formed in a cylindrical shape surrounding a jet nozzle 40, and an electromagnetic coil 51 may be wound along a height direction of the cylindrical-shaped core 54. Also, in one embodiment of the present invention, as illustrated in FIG. 4(B), a groove 55 is formed in a soft ferrite core 54, and it may be a structure that an electromagnetic coil 51 is embedded and wound in the groove 55. In this way, the electromagnetic coil 51 can be embedded in the soft ferrite core 54, and can be fixed such that a position of the electromagnetic coil 51 will not be deviated while the jet soldering apparatus 100 is operating. In addition, with regard to the groove 55 of the soft ferrite core 54, the electromagnetic coil 51 may be wound along one groove, or a plurality of slits may be formed at a wall of the groove and the electromagnetic coil 51 may be wound back respectively at outside or inside of the wall. In FIG. 4(A) and FIG. 4(B), the electromagnetic coil 51 comprises a copper wire in a glass tube, but it is not limited to this configuration, and a material, a thickness, a winding number of a coil, and else may be selected accordingly according to an extent of preheating, a position of preheating, and else.

FIG. 5 is a view illustrating an embodiment of an installation of an electromagnetic coil including a soft ferrite core relating to a preheating mechanism relating to other embodiment of the present invention. In other embodiment of the present invention, a soft ferrite core 54 is having a U shape, and the U-shaped core 54 may be arranged at one or plural positions around the jet nozzle 40. For example, in FIG. 3(B), electromagnetic coils 51A, 51B and soft ferrite cores 54A, 54B are arranged at two positions interposing the jet nozzle 40, but they may be arranged at four positions, front, rear, left and right of the jet nozzle 40, or they may be arranged at more than four positions. (In addition, also in FIG. 3(A), the electromagnetic coil 51 and the soft ferrite core 54 are illustrated at left and right of the jet nozzle 40 to interpose the jet nozzle 40, but in the embodiment of FIG. 3(A), the soft ferrite core 54 is in a cylindrical shape, so left and right electromagnetic coil 51 and soft ferrite core 54 are connected in one circular shape.) The on/off control can be performed per each electromagnetic coil 51A, 51B, when each electromagnetic coil 51A, 51B is connected to the alternating current power source and the controller 53 individually. In addition, also in the embodiment of FIG. 5, a material, a thickness, a winding number of a coil, and else may be selected accordingly according to an extent of preheating, a position of preheating, and else.

### Examples

The present invention is further explained in detail by examples indicated below, but the present invention should not be limited by these examples.

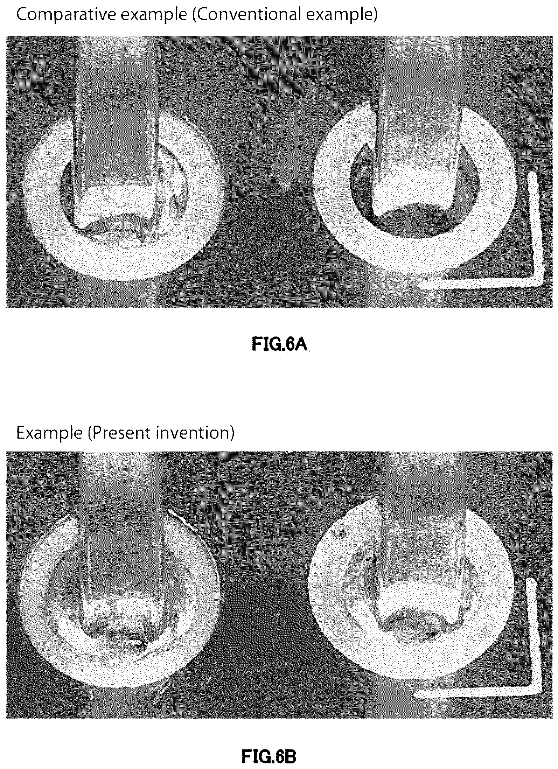

FIG. 6(A) is a view illustrating a state seen from a component surface side when a component lead is soldered to a through hole by a conventional jet soldering (comparative example), and FIG. 6(B) is a view illustrating a state seen from a component surface side when a component lead is soldered to a through hole by a jet soldering applying the preheating mechanism relating to the present invention (example).

In a comparative example (conventional example) of FIG. 6(A), it can be seen that a gap is generated in a through hole seen from a component surface side, and it can be seen that a solder is not risen up to an upper portion of the through hole. On the other hand, in the example (present invention) of FIG. 6(B), it can be seen that a solder seen from a component surface side is filled to an upper portion of the through hole.

As the above, according to the present invention, it is confirmed that a preheating mechanism of a jet soldering apparatus capable of heating efficiently until an upper portion of a through hole of a substrate, and in which a solder reaches an upper portion of the hole without stopping a wetting by a solidification of a solder, is achieved.

In addition, it is explained in detail about each embodiment and each example of the present invention as the above, but it can be understood easily for those who skilled in the art that various modifications can be made without practically departing from new matters and effect of the present invention. Therefore, all such variants should be included in the scope of the present invention.

For example, terms described with different terms having broader or equivalent meaning at least once in description and drawings can be replaced with these different terms in any part of description and drawings. In addition, configurations of the preheating mechanism of the jet soldering apparatus and the jet soldering apparatus are not limited to those explained in each embodiment and each example of the present invention, and various modifications can be made.

### Glossary of Drawing References

1 Molten solder
10 Printed circuit board
11 Land
12 Through hole
13 Substrate
14 Lead terminal
15 Solder bath
20 Work supporting means
21 to 25 Roller
26 Chain
27 Conveying direction
30 Soldering position
31 Work fixing table
33 Access means
33X X axis drive unit
33YZ Table strut
40 Jet nozzle
50 Preheating mechanism
51, 51A, 51B Electromagnetic coil
52 Mounting unit
53 Alternating current power source and controller
54, 54A, 54B Soft ferrite core
55 Groove
56 Heating gas supply mechanism
60 Access means (nozzle drive unit)
61 Control device
100, 200 Jet soldering apparatus
F Magnetic force line
H Heating gas

## Claims

1. A preheating mechanism of a jet soldering apparatus for preheating a soldering position of a printed circuit board and its periphery, associated with a soldering apparatus for partially soldering the soldering position of the printed circuit board by drawing up a molten solder from a jet nozzle, at least comprising:
one or more electromagnetic coils;
a mounting unit for mounting the one or more electromagnetic coils at a periphery of the jet nozzle; and
an alternating current power source and a controller for flowing an alternating current to the one or more electromagnetic coils and for controlling on/off of the alternating current,
wherein the mounting unit is arranged at a position that the soldering position of the printed circuit board and its periphery can be preheated by an electromagnetic induction heating using the one or more electromagnetic coils, and a timing of heating, a heating time, and a power applied to the one or more electromagnetic coils are controlled by the alternating current power source and the controller.

2. The preheating mechanism of the jet soldering apparatus according to claim 1, wherein a soft ferrite core is applied to the one or more electromagnetic coils.

3. The preheating mechanism of the jet soldering apparatus according to claim 1, wherein the preheating mechanism further comprises a heated gas supply mechanism for supplying a heated gas to the printed circuit board.

4. The preheating mechanism of the jet soldering apparatus according to claim 2, wherein a Curie temperature of the soft ferrite core is 200 degrees Celsius or more.

5. The preheating mechanism of the jet soldering apparatus according to claim 4, wherein the soft ferrite core is formed in a cylindrical shape surrounding the jet nozzle, and an electromagnetic coil of the one or more electromagnetic coils is wound along a height direction of the core in a cylindrical shape.

6. The preheating mechanism of the jet soldering apparatus according to claim 4, wherein the soft ferrite core is formed in a U shape, and the core in U shape is arranged at one or more positions around the jet nozzle.

7. The preheating mechanism of the jet soldering apparatus according to claim 5, wherein a groove is formed in the soft ferrite core, and the electromagnetic coil is embedded and wound in the groove.

8. A jet soldering apparatus comprising the preheating mechanism according to any of claims 1 to 7, the jet soldering apparatus comprising:
a work supporting means for supporting a work in which a plurality of soldering positions are dispersed;
a jet nozzle for ejecting a molten solder to a soldering position of the plurality of soldering positions;
a preheating mechanism arranged at a periphery of the jet nozzle; and
an access means in which respective distances from the jet nozzle to the plurality of soldering positions are moved closer when automatic soldering is performed and the respective distances are moved away while waiting.
